(19) Europäisches Patentamt / European Patent Office / Office européen des brevets

(11) **EP 2 013 631 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(51) Int Cl.:
***G01R 27/26*** (2006.01)

(21) Anmeldenummer: **07728120.2**

(22) Anmeldetag: **13.04.2007**

(86) Internationale Anmeldenummer:
**PCT/EP2007/053655**

(87) Internationale Veröffentlichungsnummer:
**WO 2007/122123 (01.11.2007 Gazette 2007/44)**

(54) **VERFAHREN UND SCHALTUNGSANORDNUNG ZUM MESSEN EINER KAPAZITÄT**

METHOD AND CIRCUIT ARRANGEMENT FOR MEASURING A CAPACITANCE

PROCÉDÉ ET CIRCUIT PERMETTANT DE MESURER UNE CAPACITÉ

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **21.04.2006 DE 102006019187**

(43) Veröffentlichungstag der Anmeldung:
**14.01.2009 Patentblatt 2009/03**

(73) Patentinhaber: **Huf Hülsbeck & Fürst GmbH & Co. KG**
**42551 Velbert (DE)**

(72) Erfinder:
• **WEBER, Franz-Josef**
 **40699 Erkrath (DE)**
• **WITTE, Martin**
 **48683 Ahaus (DE)**

(74) Vertreter: **Zenz**
 **Patent- und Rechtsanwälte**
 **Rüttenscheider Straße 2**
 **45128 Essen (DE)**

(56) Entgegenhaltungen:
JP-A- 2003 104 165    US-A- 5 586 042
US-A1- 2006 006 883    US-B1- 6 661 239

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Messen einer Kapazität, wobei eine über der Kapazität anliegende Spannung einem Eingang einer Auswerteschaltung zugeführt wird und wobei die Kapazität aus einem Spannungsendwert bestimmt wird, der sich nach einem Entladen der Kapazität von einer vorgegebenen Anfangsspannung für eine vorgegebene Zeitdauer über einen vorgegebenen Widerstand ergibt. Ferner betrifft die Erfindung eine Schaltungsanordnung zum Messen einer Kapazität nach einem solchen Verfahren.

Wenn eine auf einen vorgegebenen Spannungswert aufgeladene Kapazität (beispielsweise eines Kondensators) über einen Widerstand entladen wird, so fällt die Spannung ausgehend von dem Anfangswert exponentiell ab nach der Formel:

$$U\left(t\right) = U_0 \cdot e^{-\frac{t}{RC}} ,$$

wobei $U_0$ die Anfangsspannung, R der Wert des Widerstands und C die Kapazität (des Kondensators) ist. Wenn nach einem vorgegebenen Zeitintervall T nach Beginn der Entladung über dem Kondensator eine Spannung $U_{meß}$ gemessen würde, so könnte aus den Werten von $U_{meß}$, T, $U_0$ und R die Kapazität bestimmt werden nach der Formel:

$$C = \frac{T}{R} \cdot \ln \frac{U_0}{U_{meß}} .$$

Eine Bestimmung der Kapazität unter Verwendung dieser Formel wäre beispielsweise möglich, wenn die Werte von $U_0$ und R möglichst exakt vorgegeben werden könnten und eine möglichst genaue Messung von $U_{meß}$ zu einem möglichst exakt festgelegten Zeitpunkt T erfolgen könnte. Bekannte Schaltungsanordnungen zum Bestimmen der Kapazität auf diese Weise sind jedoch entweder schaltungstechnisch sehr aufwendig (und teuer) oder aufgrund einer Vielzahl von Störeinflüssen relativ ungenau.

Die Anforderungen an die Genauigkeit sind dann geringer, wenn nicht die Kapazität selbst, sondern nur eine relative Änderung der Kapazität über eine vorgegebene Zeitdauer ermittelt werden soll. In diesem Fall ist die genaue Kenntnis der Werte von $U_0$ und R nicht erforderlich; diese Werte müssen nur über die bestimmte Zeitdauer konstant gehalten werden. Auch ist die exakte Dauer des Zeitintervalls T von untergeordneter Bedeutung; es muß nur bei jeder Messung möglichst die gleiche Zeitdauer zwischen dem Beginn des Entladens und dem Meßzeitpunkt vergehen. Lediglich eine möglichst genaue Messung der Spannung $U_{meß}$ ist in einem solchen Fall erforderlich.

Die US5586042A beschreibt ein Verfahren zur Messung einer Kapazität mit einer Serienanordnung von Widerstand und Kapazität, wobei die Ladungscharakteristik für die Bestimmung herangezogen wird.

Die US6661239B1 beschreibt ein Verfahren zur Kapazitätsmessung, wobei ein Kondensator entladen wird und die Zeit bis zum Erreichen eines bestimmten Spannungswertes ermittelt wird, um die Kapazität zu bestimmen.

Ein Anwendungsbeispiel, bei dem weniger die Bestimmung der absoluten Kapazität als vielmehr die Bestimmung der relativen Kapazitätsänderung gewünscht wird, sind kapazitive Annäherungssensoren zur Erfassung der Annäherung eines Bedienerkörperteils an einen Türgriff eines Kraftfahrzeugs.

Aufgabe der Erfindung ist es, eine preiswerte und zuverlässige Möglichkeit einer Kapazitätsmessung für einen kapazitiven Annäherungssensor zu schaffen.

Diese Aufgabe wird erfindungsgemäß durch ein Verfahren mit den Merkmalen des Anspruchs 1 bzw. eine Schaltungsanordnung mit den Merkmalen des Anspruchs 10 gelöst.

Die Erfindung geht aus von dem eingangs genannten Grundprinzip der Bestimmung einer Kapazität auf der Grundlage einer Spannungsmessung nach einer vorgegebenen Entladezeit. Der Erfindung liegt ferner die Erkenntnis zugrunde, daß eine die Spannung über der Kapazität erfassende Auswerteschaltung nicht über dem gesamten Intervall der über der Kapazität auftretenden Spannungen exakt zu messen braucht, sondern daß lediglich in einem kleinen Teilintervall, das hier als Meßintervall bezeichnet wird, eine möglichst genaue Spannungsmessung erforderlich ist, wobei dieses Meßintervall so gewählt wird, daß der Spannungsendwert, der nach einem Entladen der Kapazität ausgehend von einer Anfangsspannung über einen vorgegebenen Widerstand für eine vorgegebene Zeitdauer erreicht wird, in dem Meßintervall liegen muß.

Bei dem erfindungsgemäßen Verfahren zum Messen einer Kapazität wird eine über der Kapazität anliegende Spannung einem Eingang einer Auswerteschaltung zugeführt, wobei die Auswerteschaltung so ausgebildet ist, daß sie Eingangsspannungen, sofern diese in einem Meßintervall liegen, mit einer vorgegebenen Genauigkeit erfassen kann. Die Kapazität wird zunächst auf eine vorgegebene Anfangsspannung, die ein Mehrfaches einer Obergrenze des Meßintervalls übersteigt, aufgeladen. Dann wird die Kapazität über einen vorgegebenen Widerstand eine vorgegebene Zeitdauer entladen, wodurch die Spannung über der Kapazität einen von der Größe der Kapazität abhängigen Spannungsendwert erreicht, wobei der Widerstand und das Zeitintervall so gewählt werden, daß der Spannungsendwert in dem Meßintervall liegt. Schließlich wird der Spannungsendwert von der Auswerteschaltung erfaßt und aus dem Spannungsendwert die Kapazität bestimmt. Die Kapazität wird aus dem Spannungsendwert beispielsweise durch Nachschlagen in einer Tabelle oder durch Berechnung nach der eingangs genannten Formel bestimmt. Wesentlich für die Erfindung ist, daß die Auswerteschaltung die Eingangsspannung nur in diesem Meßintervall mit der vorgegebenen Genauigkeit erfassen kann. Liegt die Eingangsspannung oberhalb oder unterhalb des Meßintervalls, so darf die Auswerteschaltung die Eingangsspannung nur mit einer deutlich geringeren Genauigkeit erfassen oder lediglich feststellen, daß sie über der Obergrenze oder unter der Untergrenze des Meßintervalls liegt. Kern der Erfindung ist somit eine Auswerteschaltung mit einer "Lupenfunktion" derart, daß die Eingangsspannung nicht mehr im gesamten Bereich aller möglichen Eingangsspannungswerte mit etwa gleicher Genauigkeit erfaßt wird, sondern die genaue Erfassung der Eingangsspannung auf ein Teilintervall (Meßintervall) beschränkt wird. Dies ermöglicht mit einer relativ einfachen Auswerteschaltung eine relativ hohe Genauigkeit der Erfassung des Spannungsendwerts.

Besonders vorteilhaft ist das erfindungsgemäße Verfahren dann, wenn nicht der Absolutwert der Kapazität sondern nur die relative Kapazitätsänderung erfaßt werden soll. In diesem Fall ist weder eine präzise Kenntnis des Widerstandswerts oder der Anfangsspannung noch eine exakte Einstellung eines Zeitintervalls erforderlich; diese Werte brauchen lediglich von Messung zu Messung konstant gehalten zu werden. Es ist lediglich eine möglichst genaue Bestimmung der verschiedenen Spannungsendwerte in dem Meßintervall erforderlich. Die Anfangsspannung, der Widerstandswert und die vorgegebene Zeitdauer werden dann so gewählt, daß die Spannungsendwerte für sämtliche zu erwartenden Kapazitätswerte der sich ändernden Kapazität in dem Meßintervall liegen.

Bei einer bevorzugten Ausführungsform des erfindungsgemäßen Verfahrens wird die über der Kapazität anliegende Spannung einem Eingang eines Verstärkers als Bestandteil der Auswerteschaltung zugeführt, wobei die Eingangsspannung des Verstärkers dann, wenn sie im Meßintervall liegt, um wenigstens den Faktor 2 verstärkt wird. Somit wird der Spannungsendwert um wenigstens den Faktor 2 verstärkt und der verstärkte Spannungsendwert erfaßt. Bei Eingangsspannungen oberhalb des Meßintervalls wird der Verstärker übersteuert, d. h. die Ausgangsspannung des Verstärkers nimmt einen (nicht mehr von dem konkreten Wert der Eingangsspannung abhängigen) Maximalwert an. An dieser Stelle sei darauf hingewiesen, daß die Begriffe "oberhalb des Meßintervalls" oder "Maximalwert" bei negativer Polung gegebenenfalls durch die äquivalenten Begriffe "unterhalb des Meßintervalls" und "Minimalwert" zu ersetzen sind oder daß die Begriffe so zu interpretieren sind, daß sie unabhängig vom Vorzeichen für die Absolutwerte der Spannungen gelten. Bei der bevorzugten Ausführungsform wird der Spannungsendwert beispielsweise mittels eines Operationsverstärkers um einen Faktor zwischen 10 und 1000, vorzugsweise zwischen 10 und 50, verstärkt. Hierzu ist ein relativ preiswerter Operationsverstärker ausreichend. Bei einer bevorzugten Ausführungsform wird dann der verstärkte Spannungsendwert erfaßt, indem mittels einer Analog-Digital-Umsetzung ein digitaler Endwert erzeugt und der erzeugte digitale Endwert gespeichert wird. Bei alternativen Ausführungsformen könnte anstelle der Kombination eines Operationsverstärkers mit einem Analog-Digital-Umsetzer auch ein Analog-Digital-Umsetzer mit einer nichtlinearen Empfindlichkeit derart eingesetzt werden, daß dieser lediglich Spannungen in dem Meßintervall mit einer hohen Auflösung umsetzt, während Spannungswerte außerhalb des Meßintervalls mit einer geringen Auflösung in Digitalwerte umgesetzt werden.

Bei einer vorteilhaften Weiterbildung der Erfindung wird die Spannung über der Kapazität nach Erreichen des Spannungsendwerts für eine zweite vorgegebene Zeitdauer gehalten, während der Spannungsendwert erfaßt wird. Dies gestattet einen relativ langsamen Operationsverstärker und Analog-Digital-Umsetzer und verringert die Kosten der Schaltung weiter.

Bei einer bevorzugten Ausführungsform wird das Aufladen auf die Anfangsspannung, das Entladen über den Widerstand und das Halten der Spannung durch abwechselndes Verbinden und Entkoppeln eines mit dem Anschluß des Kondensators verbundenen Knotens mit einer Spannungsquelle oder einem Massepotential ausgeführt, wobei das Verbinden und Entkoppeln mit Hilfe von Schaltern ausgeführt wird, die von einer Steuereinrichtung gesteuert werden. Die Schalter sind vorzugsweise elektronische Schalter und die Steuereinrichtung umfaßt vorzugsweise einen Mikroprozessor oder Mikrocontroller.

Bei einer bevorzugten Weiterbildung wird die vorgegebene Zeitdauer von einem Prozessor (einem Mikroprozessor oder Mikrocontroller) in Abhängigkeit von einem Taktsignal bestimmt. Die zeitliche Konstanz dieses Taktsignals wird beispielsweise durch Einsatz eines Quarzoszillators für die Takterzeugung erreicht. Das erfindungsgemäße Verfahren kann somit mit einer relativ einfachen Schaltungsanordnung ausgeführt werden, die neben wenigen Widerstandsbauelementen einen preiswerten Operationsverstärker und einen Mikrocontroller mit einem Analog-Digital-Umsetzer-Eingang umfaßt.

Bei der erfindungsgemäßen Schaltungsanordnung zum Messen einer Kapazität eines Kondensators ist ein Anschluß des Kondensators mit einem Eingangsknoten einer Auswerteschaltung verbunden und der andere Anschluß des Kondensators mit einem Bezugspotential (beispielsweise Massepotential). Wie bereits zu dem Verfahren ausgeführt, ist die Auswerteschaltung so ausgebildet, daß sie eine Eingangsspannung, sofern diese in einem Meßintervall liegt, mit einer vorgegebenen Genauigkeit erfaßt und einen entsprechenden Ausgangswert erzeugt (der Ausgangswert kann beispielsweise eine Ausgangsspannung oder auch ein Ausgangsdigitalwert oder Code sein, der der Spannung entspricht). Eine erste Schalteinrichtung kann den Eingangsknoten mit einem konstanten Spannungspotential (beispielsweise dem positiven Spannungsversorgungspotential, welches zumindest innerhalb der Größenordnung einiger Meßintervalle konstant bleibt) verbinden. Eine zweite Schalteinrichtung kann einen Widerstand vorgegebener Größe (z. B. ein Präzisionswiderstandsbauelement) zwischen dem Eingangsknoten und dem Bezugspotential einkoppeln. Mit der ersten und der zweiten Schalteinrichtung ist eine Steuereinrichtung gekoppelt, welche die Schalteinrichtungen derart ansteuert, daß (a) der Eingangsknoten mit dem konstanten Spannungspotential verbunden wird, wobei die Auswerteschaltung einen Ausgangswert erzeugt, der dann, wenn der Eingangsknoten auf dem konstanten Spannungspotential liegt, einen Extremwert (Maximalwert oder Minimalwert) annimmt, (b) dann der Widerstand zwischen dem Eingangsknoten und dem Bezugspotential (Masse beispielsweise) für eine vorgegebene Zeitdauer eingekoppelt wird, so daß die Spannung zwischen dem Eingangsknoten und dem Bezugspotential auf einen in dem Meßintervall liegenden Endwert abfällt, und (c) dann der Eingangsknoten von dem Bezugspotential und dem konstanten Spannungspotential derart entkoppelt (hochohmig) wird, daß die Spannung auf dem Endwert gehalten wird, wobei die Auswerteschaltung einen Ausgangswert erzeugt, der proportional zu dem Endwert ist. Der Ausgang der Auswerteschaltung ist mit einer Einrichtung zum Speichern des Ausgangswerts und Bestimmen eines zugehörigen Kapazitätswerts gekoppelt. Diese Einrichtung könnte beispielsweise ein Mikrocontroller sein.

Vorzugsweise ist die Schaltungsanordnung **dadurch gekennzeichnet, daß** die Auswerteschaltung einen Operationsverstärker und einen mit dem Ausgang des Operationsverstärkers gekoppelten Analog-Digital-Umsetzer aufweist, wobei der Analog-Digital-Umsetzer den Ausgangswert erzeugt. Der Eingangsknoten kann mit dem invertierenden Eingang des Operationsverstärkers verbunden sein. Der Operationsverstärker hat beispielsweise eine Verstärkung zwischen 2 und 1000, vorzugsweise zwischen 10 und 50.

Bei einer bevorzugten, einfachen Ausgestaltung der Schaltungsanordnung ist der Eingangsknoten der Auswerteschaltung über eine Parallelschaltung des Widerstands vorgegebener Größe und einer Schaltdiode mit einem Ausgangsanschluß eines Controllers (Mikrocontrollers) verbunden. Der Ausgangsanschluß des Controllers kann auf dem Bezugspotential (Masse; logisch niedriger Pegel) oder dem konstanten Spannungspotential (Versorgungsspannung, logisch hoher Pegel) liegen oder hochohmig sein. Somit wird bei dieser Ausführungsform die erste Schalteinrichtung von der Schaltdiode und dem Controller und die zweite Schalteinrichtung von dem Controller allein gebildet. Die erste Schalteinrichtung ist "eingeschaltet", d. h. verbindet den Eingangsknoten mit dem konstanten Spannungspotential, wenn der Ausgangsanschluß des Controllers auf logisch hohem Pegel liegt und die Schaltdiode somit in Durchlaßrichtung geschaltet ist. Die zweite Schalteinrichtung ist "eingeschaltet" und verbindet den Eingangsknoten über dem Widerstand mit dem Bezugspotential (Masse), wenn der Ausgang des Controllers sich auf niedrigem Pegel (Masse beispielsweise) befindet.

Vorteilhafte und/oder bevorzugte Weiterbildungen der Erfindung sind in den Unteransprüchen gekennzeichnet.

Im folgenden wird die Erfindung anhand eines in den Zeichnungen dargestellten bevorzugten Ausführungsbeispiels näher erläutert. In den Zeichnungen zeigen:

Figur 1 ein schematisches Schaltbild der erfindungsgemäßen Schaltungsanordnung; und
Figuren 2A und 2B beispielhafte Spannungsverläufe der Spannung über der Kapazität und der Spannung am Ausgang eines Operationsverstärkers.

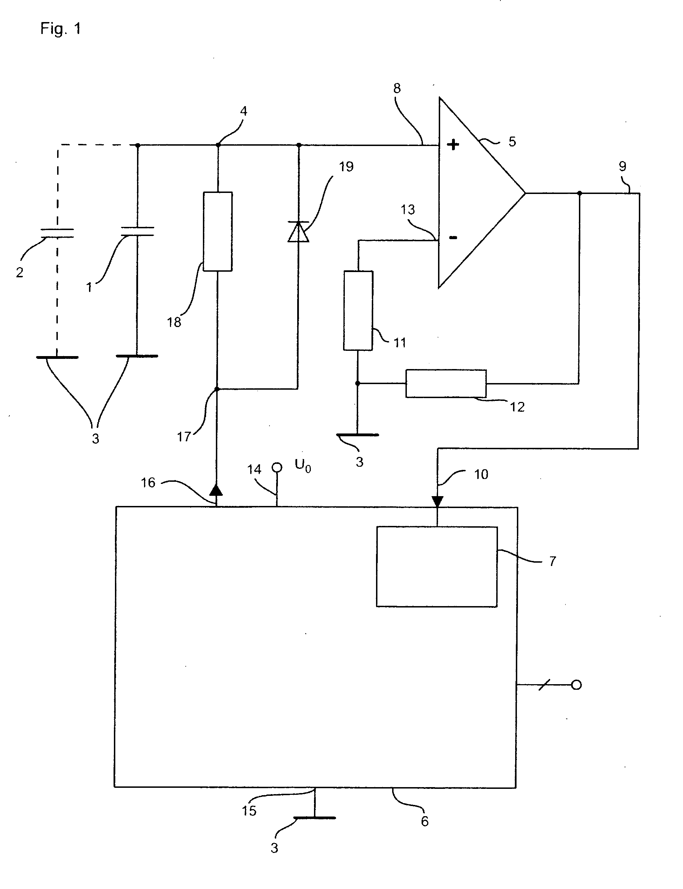

Figur 1 zeigt eine schematische Darstellung einer erfindungsgemäßen Schaltungsanordnung zum Bestimmen einer Kapazität. Die zu bestimmende Kapazität setzt sich zusammen aus der Summe eines Schaltungskondensators 1 und eines (in Figur 1 mit gestrichelten Zuleitungen dargestellten) "Störkondensators'" 2. Bei der bevorzugten Anwendung der Schaltungsanordnung für einen kapazitiven Annäherungssensor ist der Schaltungskondensator 1 fester Bestandteil der Schaltungsanordnung und so ausgebildet, daß seine Kapazität unter den zu erwartenden Umgebungsbedingungen möglichst konstant ist. Bei der als "Störkondensator" bezeichneten Kapazität 2 handelt es sich um die Kapazität, die eine Elektrode eines kapazitiven Annäherungssensors gegenüber der Masse aufweist. Diese Kapazität hängt einerseits von der konstruktiven Gestaltung des kapazitiven Sensors (Fläche der Elektrode, Abstand der Elektrode zu Massebauteilen, umgebendes Dielektrikum) und andererseits von der Nähe und Größe eines sich an die Elektrode annähernden und mit Masse kapazitiv und/ oder resistiv gekoppelten Objekts (beispielsweise der Hand eines Benutzers) ab. Die gezeigte Schaltungsanordnung dient hauptsächlich dazu, die Änderungen der Kapazität 2 zu erfassen und zu verfolgen und aus diesen Änderungen eine Aussage über die Annäherung der Hand eines Bedieners abzuleiten. Die Gestaltung einer Elektrodenanordnung eines solchen kapazitiven Annäherungssensors sowie die Funktion (beispielsweise bei der Anordnung in Kraftfahrzeugtürgriffen) sind bekannt und sollen hier nicht näher beschrieben werden.

Wie in Figur 1 dargestellt, ist jeweils ein Anschluß der Kapazitäten 1,2 mit Masse 3 als Bezugspotential verbunden, während der andere Anschluß des Kondensators 1 bzw. der Kapazität 2 mit einem Eingangsknoten 4 der als Auswerteschaltung bezeichneten Schaltung zum Bestimmen der Kapazität gekoppelt ist. Die Auswerteschaltung wird bei dem in Figur 1 dargestellten Ausführungsbeispiel im wesentlichen von einem Operationsverstärker 5 und einem in einem Mikrocontroller 6 enthaltenen Analog-Digital-Umsetzer 7 gebildet. Der Eingangsknoten 4 ist hierbei mit dem nicht-invertierenden Eingang 8 des Operationsverstärkers 5 verbunden. Der Ausgang 9 des Operationsverstärkers ist mit einem Eingangsanschluß 10 des Mikrocontrollers 6 verbunden, wobei der Eingangsanschluß 10 mit dem Eingang des Analog-Digital-Umsetzers 7 verbunden ist. Zur Einstellung der gewünschten Verstärkung ist der Ausgang 9 des Operationsverstärkers 5 über ein Widerstandsnetzwerk aus den Widerständen 11 und 12 mit dem invertierenden Eingang 13 des Operationsverstärkers 5 und Masse 3 gekoppelt. Die Verstärkung des Operationsverstärkers wird auf einen Wert zwischen 10 und 50 eingestellt, so daß der Betrag der Ausgangsspannung am Ausgang 9 das 10- bis 50-fache der Spannung auf dem Eingangsknoten 4 beträgt.

Der Mikrocontroller 6 enthält neben dem Analog-Digital-Umsetzer 7 eine Reihe weiterer Schaltungskomponenten, die einen Prozessor, einen RAM, einen ROM und weitere Eingangs- und Ausgangsschaltungen, wie beispielsweise Analog-Digital-Umsetzer, Digital-Analog-Umsetzer und Treiberschaltungen, umfassen. Die Spannungsversorgung des Mikrocontrollers ist symbolisch durch den Anschluß 14 dargestellt, an den die Spannung $U_0$ angelegt ist. Daneben ist ein mit Masse 3 gekoppelter Anschluß 15 gezeigt. Selbstverständlich kann der Mikrocontroller eine Reihe weiterer Versorgungsspannungs- und Masseanschlüsse aufweisen und kann auch mit mehreren verschiedenen Versorgungsspannungen versorgt werden.

Der Mikrocontroller 6 weist einen Ausgangsanschluß 16 auf, der drei Zustände annehmen kann. An ihm kann die Spannung $U_0$ ausgegeben werden, er kann auf Masse gelegt werden, und er kann hochohmig geschaltet werden (d.h. von Spannungspotentialen und Masse entkoppelt werden). Mit Hilfe des Steuerausgangsanschlusses 16 steuert der Mikrocontroller 6 den unten näher beschriebenen Meßablauf, indem das Potential des Ausgangsanschlusses 16 zu fest vorgegebenen Zeitpunkten innerhalb eines Meßablaufs auf die Spannung $U_0$ oder auf Masse gelegt oder hochohmig geschaltet wird. Die Meßabläufe einschließlich der Ansteuerung des Ausgangsanschlusses 16 und der Verarbeitung der Ausgangssignale des Analog-Digital-Umsetzers 7 werden von einem in dem Mikrocontroller enthaltenen Programm gesteuert.

Der Ausgangsanschluß 16 ist mit einem Steuerknoten 17 der Meßschaltung verbunden, der wiederum über eine Parallelschaltung aus einem Entladewiderstand 18 und einer Schaltdiode 19 mit dem Eingangsknoten 4 gekoppelt ist. Die Schaltdiode 19 ist dabei so gepolt, daß sie lediglich einen Stromfluß vom Steuerknoten 17 zum Eingangsknoten 4 durchläßt. Wenn die Spannung $U_0$ an den Steuerknoten 17 angelegt wird, so wird die Parallelschaltung der Kapazitäten 1 und 2 über die Parallelschaltung aus dem Widerstand 18 und der Schaltdiode 19, deren Widerstand im wesentlichen durch den Durchlaßwiderstand der Schaltdiode 19 bestimmt wird, aufgeladen, bis die Spannung auf dem Eingangsknoten 4 $U_0$ erreicht hat. Aufgrund des geringen Durchlaßwiderstands der Schaltdiode 19 erfolgt das relativ schnell. Wenn der Stromfluß durch die Schaltdiode 19 begrenzt werden soll, kann in den Diodenzweig in Reihe zu der Diode 19 ein weiterer Widerstand eingeschaltet werden. Dies erhöht selbstverständlich die Aufladezeit. Wenn an den Steuerknoten 17 Massepotential angelegt wird und sich der Eingangsknoten 4 auf einem höheren Potential, beispielsweise auf der Spannung $U_0$ gegenüber Masse, befindet, so wird die Parallelschaltung der Kapazitäten 1 und 2 über den Entladewiderstand 18 entladen. Stromflüsse über die in Sperrichtung gepolte Schaltdiode 19 und über die Eingänge des Operationsverstärkers 5 sind näherungsweise gleich Null, können also vernachlässigt werden. Bei einem Widerstandswert R des Entladewiderstands 18, einer Kapazität $C_1$ des Schaltungskondensators 1 und einer Kapazität $C_2$ des Störkondensators 2 ergibt sich eine Entladezeitkonstante $\tau = R(C_1 + C_2)$.

Wenn der Steuerknoten 17 und der Ausgangsanschluß 16 des Mikrocontrollers 6 hochohmig geschaltet werden, so wird die zu diesem Zeitpunkt auf dem Eingangsknoten vorhandene Spannung nahezu gehalten. Ein geringfügiger Abfall der Spannung ergibt sich aus parasitären Widerständen zwischen dem Eingangsknoten 4 und Masse, beispielsweise innerhalb des Operationsverstärkers 5, innerhalb der Ausgangstreiberschaltung des Ausgangsanschluß 16 sowie über die Kondensatoren 1 und 2 und andere Schaltungselemente.

Zum Bestimmen der Kapazität $C_1 + C_2$ steuert der Mikrocontroller 6 folgenden Meßablauf an. Zunächst wird der Ausgangsanschluß 16 auf die Spannung $U_0$ gelegt. Diese Spannung ist stabilisiert und zeitlich weitgehend konstant. Wenn an dem Steuerknoten 17 die Spannung $U_0$ anliegt, wird die Parallelschaltung der Kapazitäten $C_1 + C_2$ über die Diode 19 schnell auf die Spannung $U_0$ aufgeladen, die sich nach kurzer Zeit auf dem Eingangsknoten 4 einstellt. Anschließend wird der Ausgangsanschluß 16 sprunghaft auf Massepotential gelegt. Die Kondensatoren 1 und 2 entladen sich über den Entladewiderstand 18 expotentiell mit der oben genannten Zeitkonstante, wobei sich auf dem Einqanqsknoten 4 der folgende Spannungsverlauf ergibt:

$$U(t) = U_0 \cdot e^{-\frac{t}{R(C_1+C_2)}}.$$

Die an dem invertierenden Eingang 8 des Operationsverstärkers 5 anliegende Spannung $U_0$ ist so hoch, daß der Operationsverstärker übersteuert wird. Er bleibt übersteuert, bis die Spannung auf dem Eingangsknoten 4 exponentiell auf einen Wert abgefallen ist, der der Obergrenze eines Meßintervalls entspricht. Bei der Übersteuerung des nicht-invertierenden Eingangs 8 des Operationsverstärkers 5 bleibt der Ausgang 9 auf einem Maximalspannungswert. Nach einer von der Programmsteuerung des Mikrocontrollers 6 vorgegebenen Zeitdauer T wird der Ausgangsanschluß 16 hochohmig geschaltet, so daß die zu diesem Zeitpunkt auf dem Eingangsknoten 4 vorhandene Spannung im wesentlichen (d.h. von parasitären Entladungen abgesehen) gehalten wird. Auch der Steuerknoten 17 liegt dann auf diesem Spannungspotential. Die vorgegebene Zeitdauer T wird so gewählt, daß die zum Ende der Zeitdauer auf dem Eingangsknoten 4 vorhandene Spannung im gesamten Bereich der zu erwartenden Kapazitätsänderungen der Kapazität 2 in einem Meßintervall des Operationsverstärkers 5 liegt, aber noch nicht nahezu Null geworden ist. Dies bedeutet, daß die Zeitdauer T so gewählt wird, daß bei der höchsten zu erwartenden Kapazität (beispielsweise dann, wenn sich die Hand des Benutzers unmittelbar an der Elektrode des kapazitiven Sensors befindet) die Spannung gerade unter die Obergrenze des Meßintervalls abgefallen ist, d.h. der Operationsverstärker gerade nicht mehr übersteuert ist. Andererseits wird die Zeitdauer T nicht zu groß gewählt, um bei der geringsten zu erwartenden Kapazität noch eine meßbare Spannung zu erhalten.

Nachdem der Ausgangsanschluß 16 des Mikrocontrollers 6 hochohmig geschaltet ist, tastet der Analog-Digital-Umsetzer 7 die Spannung auf dem Ausgang 9 des Operationsverstärkers ab. Mit den oben genannten eingestellten Verstärkungswerten beträgt diese Spannung etwa das 10- bis 50-fache der Spannung auf dem Eingangsknoten 4. Bei bekannter Verstärkung kann aus dem von dem Analog-Digital-Umsetzer ausgegebenen Digitalwert die zum Ende des Zeitintervalls T auf dem Eingangsknoten 4 vorhandene Spannung und daraus (in Kenntnis der Spannung $U_0$ und des Widerstands R) die Kapazität $C_1+C_2$ nach der eingangs genannten Formel bestimmt werden.

Bei der praktischen Anwendung als Annäherungssensor sind jedoch die exakten Werte der Verstärkung, der Spannung $U_0$, des Widerstands R und des Zeitintervalls T nicht bekannt und auch von untergeordnetem Interesse, da der Mikrocontroller lediglich die relative (prozentuale) Änderung der Kapazität $C_2$ über der Zeit bestimmen soll. Zu diesem Zweck wird der oben geschilderte Meßablauf zyklisch mehrfach wiederholt. Die periodisch von dem Analog-Digital-Umsetzer ausgegebenen Digitalwerte werden gespeichert und verarbeitet, d.h. miteinander verglichen und daraus die relative Kapazitätsänderung berechnet.

Die relativen Kapazitätsänderungen liegen typischerweise im unteren Prozent- oder sogar Promille-Bereich. Dementsprechend gering sind auch die Änderungen der sich am Ende des Zeitintervalls T einstellenden Meßspannungen auf dem Eingangsknoten 4. Die erfindungsgemäße Schaltungsanordnung nutzt nun den Umstand aus, daß lediglich diese sich am Ende des Zeitintervalls T einstellende Spannung, nicht aber sämtliche sich während des Meßzyklus auf dem Eingangsknoten 4 ergebenden Spannungen, genau gemessen werden muß. Ausgehend davon wird die sich am Ende des Intervalls T ergebende Spannung mit Hilfe des Verstärkers 5 stark verstärkt (um den Faktor 10 bis 50 oder mehr) und es wird andererseits hingenommen, daß der auf die Verstärkung dieses Bereichs optimierte Operationsverstärker 5 im gesamten darüberliegenden Eingangsspannungsbereich übersteuert wird. Die aufgrund der Übersteuerung falsche Umsetzung der Eingangsknotenspannung in eine Spannung des Ausgangs 9 ist für die vorzunehmende Messung irrelevant. Es muß lediglich sichergestellt werden, daß im Bereich sämtlicher zu erwartender Kapazitätsänderungen die sich am Ende des Intervalls T ergebende Meßspannung im Meßintervall des Operationsverstärkers 5 liegt. Die Genauigkeit der Meßanordnung kann verbessert werden, indem parasitäre Stromflüsse minimiert und die zeitliche Konstanz der Spannung $U_0$ und des Widerstands R erhöht werden. Dies und ein ideales Verhalten des Operationsverstärkers 5 erlauben eine relativ lange Entladezeit T, welche zu einer relativ geringen Spannung am Ende des Zeitintervalls führt. Dann ist ein relativ kleines Meßintervall bei einem Operationsverstärker mit relativ großer Verstärkung möglich. Dies erhöht die Empfindlichkeit der Meßanordnung. Allerdings sind Rauscheinflüsse zu minimieren und Störfelder abzuschirmen. Die Meßgenauigkeit für die Kapazität $C_2$ kann auch durch eine Verringerung der Kapazität $C_1$ des Schaltungskondensators 1 vergrößert werden. Andererseits wird die Schaltung dadurch empfindlicher gegenüber Störeinflüssen.

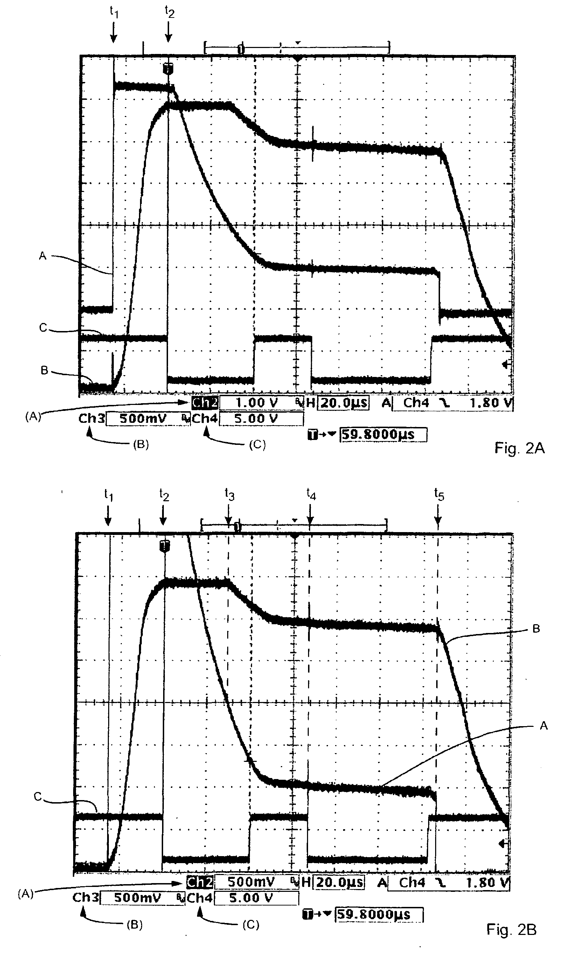

Die sich bei dem oben genannten Meßzyklus ergebenden Spannungsverläufe auf dem Eingangsknoten 4 und am Ausgang 9 sollen nachfolgend anhand der Figuren 2A und 2B näher beschrieben werden. Die Figuren 2A und 2B zeigen experimentell erfaßte Spannungsverläufe, wobei die mit A bezeichneten Verläufe die Spannung auf dem Eingangsknoten 4 darstellen, die mit B bezeichneten Verläufe die Spannung am Ausgang 9 des Operationsverstärkers und die mit C bezeichneten Verläufe ein binäres Testausgangssignal des Mikrocontrollers 6 für Statusinformationen. Figur 2B unterscheidet sich von Figur 2A lediglich darin, daß in Figur 2A für den Verlauf A ein Spannungsmaßstab gewählt wurde, der eine vollständige Darstellung des Verlaufs A gestattet, während in Figur 2B für die Verläufe A und B der gleiche Spannungsmaßstab gewählt wurde, welchem Spannungswert jeweils der vertikale Abstand zwischen zwei horizontalen gepunkteten Linien entspricht, ist aus den unter dem jeweiligen Diagramm gezeigten Kanalinformationen (Ch2, Ch3, Ch4) zu entnehmen. In Figur 2A entspricht die Höhe eines durch die gepunkteten Linien gebildeten Kästchens für den Verlauf A einer Spannung von 1,00 V, für den Verlauf B einer Spannung von 500 mV und für den Verlauf C einer Spannung von 5,00 V. In Figur 2B entspricht die Höhe eines Kästchens für die Verläufe A und B einer Spannung von 500 mV und für den Verlauf C einer Spannung von 5 V. In beiden Figuren entspricht der horizontale Abstand zwischen zwei vertikalen Punkt-Linien einer Zeitdauer von 20,0 $\mu$s.

Aus den Figuren 2A und 2B lassen sich folgende Spannungsverläufe entnehmen. Zum Zeitpunkt $t_1$ wird der Ausgangsanschluß 16 des Mikrocontrollers 6 auf die Spannung $U_0$ geschaltet, woraufhin die Spannung auf dem Eingangsknoten 4 (Verlauf A) sprunghaft auf einen Wert von etwa 5,4 V ansteigt, da der Kondensator über die Schaltdiode 19 aufgeladen wird (bei der Auflösung der Figuren 2A und 2B ist das Einschwingen der Knotenspannung nicht zu erkennen). Während die Spannung auf dem Eingangsknoten 4 auf dem Wert $U_0$ gehalten wird, folgt die Spannung am Ausgang 9 des Operationsverstärkers (Verlauf B) diesen Spannungsanstieg, bis die Sättigungsgrenze (der Maximalwert) von etwa 3,4 V erreicht ist. Die Eingangsspannung von 5,4 V übersteuert den Operationsverstärker. Man erkennt in den Figuren 2A und 2B, daß der Operationsverstärker langsam (innerhalb von etwa 20 $\mu$s) einschwingt. Nachdem das Ausgangssignal des Operationsverstärkers den Maximalwert erreicht hat, wird der Ausgang 16 des Controllers 6 zum Zeitpunkt $t_2$ sprunghaft auf Masse gelegt, was durch einen sprunghaften Abfall des Statussignals (Verlauf C) angezeigt ist. Zum Zeitpunkt $t_2$ beginnt somit die Entladung der Kapazität; die Spannung auf dem Eingangsknoten 4 (Verlauf A) fällt exponentiell ab. Währens des Abfallens unterschreitet die Spannung auf dem Eingangsknoten 4 zum Zeitpunkt $t_3$ die Obergrenze des Meßintervalls; der Operationsverstärker ist nicht mehr übersteuert und die Ausgangsspannung (Verlauf B) folgt ab diesem Zeitpunkt $t_3$ der Knotenspannung auf dem Eingangsknoten 4. Bei den in den Figuren 2A und 2B dargestellten Beispielen beträgt die Spannung am Ausgang 9 etwa das 3-fache der Eingangsspannung. Zum Zeitpunkt $t_4$ wird der Ausgangsanschluß 16 des Mikrocontrollers 6 hochohmig geschaltet, woraufhin die Spannung am Eingangsknoten im wesentlichen gehalten wird, d.h. nur noch geringfügig abfällt. Zum Zeitpunkt $t_5$ wird der Eingangsknoten 4 auf Masse gelegt, so daß die Spannung sprunghaft auf Null abfällt. Hier sei angemerkt, daß das Schaltelement, mit dem der Knoten 4 niederohmig auf Masse gelegt werden kann, in Figur 1 zur Vereinfachung nicht dargestellt worden ist. Dieses Schaltelement kann auch entfallen und der Eingangsknoten 4 über den Entladewiderstand 18 und den Anschluß 16 auf Masse entladen werden. Dies würde aber mit derselben Zeitkonstante und demselben exponentiellen Abfall geschehen, wie er im Zeitintervall zwischen $t_2$ und $t_4$ zu erkennen ist.

Bei einer beispielhaften Meßanordnung wurden ein Schaltungskondensator 1 von etwa 20pF und ein Entladewiderstand von etwa 560 k$\Omega$ verwendet, woraus sich eine Zeitkonstante $\tau$ von etwa 13 $\mu$s ergab. Bei einer Abschätzung der Empfindlichkeit der Meßanordnung wurde ferner angenommen, daß der Störkondensator 2 eine Kapazität von etwa 1 % des Schaltungskondensators 1, also etwa 0,2 pF aufweist. Bei einer Meßzeit T = $\tau$ (= $RC_1$ - ohne Störkondensator) und einer Spannung von $U_0$ = 5V ergibt sich ohne Störkondensator eine gemessene Spannung von 1,839 V und mit Störkondensator eine Spannung von 1,858 V. Die Differenz von 19 mV betrögt etwa 1 % der gemessenen Spannung. Bei einer Meßzeit von T = 2 $\tau$ und ansonsten gleichen Verhältnissen ergibt sich eine Meßspannung von 0,6766 V ohne Störkondensator und 0,6902 V mit Störkondensator. Die Differenz von 13,6 mV entspricht etwa 2 % der Spannung. Bei einer Meßzeit von T = 3 $\tau$ ergibt sich ohne Störkondensator eine Spannung von 0,2489 V und mit Störkondensator eine Spannung von 0,2564 V. Die Differenz von 7,5 mV beträgt etwa 3% der Spannung. Spannungsänderungen im Bereich einiger Prozent lassen sich mit einem preiswerten Analog-Digital-Umsetzer gut auflösen. Eine längere Meßzeit führt zu einer höheren Empfindlichkeit der Meßanordnung. Allerdings erfordern die sich ergebenden geringeren Spannungen präzisere Analogschaltungen.

Im Rahmen des Erfindungsgedankens sind alternative Ausführungsformen denkbar. Beispielsweise braucht aus dem digitalen Ausgangswert des Analog-Digital-Umsetzers die zugehörige Kapazität nicht berechnet zu werden, sie kann zur Erhöhung der Geschwindigkeit auch in einer Nachschlagetabelle nachgeschlagen werden, wobei die Nachschlagetabelle aufgrund zuvor gemessener Werte erstellt wird. Darüber hinaus ist es bei einer Erfassung einer relativen Kapazitätsänderung nicht erforderlich, die ausgegebenen Digitalwerte des Analog-Digital-Umsetzers 7 unmittelbar in Kapazitätswerte umzurechnen; die Spannungswerte können direkt verglichen und weiterverarbeitet werden. Darüber hinaus können zusätzliche Schaltungselemente enthalten sein. Beispielsweise braucht der nicht mit dem Eingangsknoten 4 verbundene Anschluß des Kondensators 1 nicht direkt mit Masse 3 verbunden zu sein; es kann beispielsweise ein Widerstand eingekoppelt sein. Wie bereits gesagt, kann auch ein Widerstand in Reihe zu der Diode 19 eingeschaltet sein.

**Patentansprüche**

1. Verfahren zum Messen einer Kapazität (1, 2), wobei eine über der Kapazität (1, 2) anliegende Spannung einem Eingang (4) einer Auswerteschaltung (5, 6, 7) zugeführt wird, wobei die Auswerteschaltung (5, 6, 7) so ausgebildet ist, daß sie Eingangsspannungen, sofern diese in einem Meßintervall liegen, mit einer vorgegebenen Genauigkeit erfassen kann, wobei:

    a) die Kapazität (1, 2) auf eine vorgegebene Anfangsspannung, die ein Mehrfaches einer Obergrenze des Meßintervalls übersteigt, aufgeladen wird,
    b) die Kapazität (1, 2) über einen vorgegebenen Widerstand (18) eine vorgegebene Zeitdauer entladen wird, wodurch die Spannung über der Kapazität (1, 2) einen von der Größe der Kapazität abhängigen Spannungsendwert erreicht, wobei der Widerstand und das Zeitintervall so gewählt werden, daß der Spannungsendwert in dem Meßintervall liegt,

c) der Spannungsendwert von der Auswerteschaltung (5, 6, 7) erfaßt und aus dem Spannungsendwert die Kapazität (1, 2) bestimmt wird.

2. Verfahren nach Anspruch 1, **dadurch gekennzeichnet,**

   **daß** die über der Kapazität (1, 2) anliegende Spannung einem Eingang eines Verstärkers (5) als Bestandteil der Auswerteschaltung (5, 6, 7) zugeführt wird,

   **daß** die Eingangsspannung des Verstärkers (5) dann, wenn sie im Meßintervall liegt, um wenigstens den Faktor 2 verstärkt wird, so daß der Spannungsendwert um wenigstens den Faktor 2 verstärkt und der verstärkte Spannungsendwert erfaßt wird, und

   **daß** der Verstärker (5) bei Eingangsspannungen oberhalb des Meßintervalls übersteuert wird.

3. Verfahren nach Anspruch 2, **dadurch gekennzeichnet, daß** der Spannungsendwert mittels eines Operationsverstärkers (5) um einen Faktor zwischen 10 und 1000, vorzugsweise zwischen 10 und 50, verstärkt wird.

4. Verfahren nach Anspruch 2 oder 3, **dadurch gekennzeichnet, daß** der verstärkte Spannungsendwert erfaßt wird, indem mittels einer Analog-Digital-Umsetzung (7) ein digitaler Endwert erzeugt und der erzeugte digitale Endwert gespeichert wird.

5. Verfahren nach einem der Ansprüche 1 - 4, **dadurch gekennzeichnet, daß** die Spannung über der Kapazität nach Erreichen des Spannungsendwerts für eine zweite vorgegebene Zeitdauer gehalten wird, während der Spannungsendwert erfaßt wird.

6. Verfahren nach Anspruch 5, **dadurch gekennzeichnet, daß** das Aufladen auf die Anfangsspannung, das Entladen über den Widerstand (18) und das Halten der Spannung durch abwechselndes Verbinden und Entkoppeln eines mit einem Anschluß des Kondensators verbundenen Knotens mit einer Spannungsquelle oder einem Massepotential ausgeführt wird, wobei das Verbinden und Entkoppeln mit Hilfe von Schaltern ausgeführt wird, die von einer Steuereinrichtung (6) gesteuert werden.

7. Verfahren nach einem der Ansprüche 1 - 6, **dadurch gekennzeichnet, daß** die Anfangsspannung von einer konstanten Spannungsquelle zur Verfügung gestellt wird.

8. Verfahren nach einem der Ansprüche 1 - 7, **dadurch gekennzeichnet, daß** die vorgegebene Zeitdauer von einem Prozessor in Abhängigkeit von einem Taktsignal bestimmt wird.

9. Verfahren nach Anspruch 6, **dadurch gekennzeichnet, daß** die Steuereinrichtung (6) einen Prozessor umfaßt und daß die vorgegebene Zeitdauer von dem Prozessor in Abhängigkeit von einem Taktsignal bestimmt wird.

10. Schaltungsanordnung zum Messen einer Kapazität eines Kondensators (1, 2),

    wobei ein Anschluß des Kondensators mit einem Eingangsknoten (4) einer Auswerteschaltung (5, 6, 7) verbunden ist und der andere Anschluß (3) des Kondensators mit einem Bezugspotential verbunden ist, wobei die Auswerteschaltung (5,6, 7) so ausgebildet ist, daß sie eine Eingangsspannung, sofern diese in einem Meßintervall liegt, mit einer vorgegebenen Genauigkeit erfaßt und einen entsprechenden Ausgangswert erzeugt,

    wobei eine erste Schalteinrichtung (19, 6) den Eingangsknoten mit einem konstanten Spannungspotential verbinden kann,

    wobei eine zweite Schalteinrichtung einen Widerstand (18) vorgegebener Größe zwischen dem Eingangsknoten (4) und dem Bezugspotential einkoppeln kann,

    wobei eine Steuereinrichtung (6) mit der ersten und der zweiten Schalteinrichtung gekoppelt ist und diese derart ansteuert, daß

    a) der Eingangsknoten (4) mit dem konstanten Spannungspotential verbunden wird, wobei die Auswerteschaltung einen Ausgangswert erzeugt, der dann, wenn der Eingangsknoten auf dem konstanten Spannungspotential liegt, einen Extremwert annimmt,

    b) dann der Widerstand (18) zwischen dem Eingangsknoten (4) und dem Bezugspotential für eine vorgegebene Zeitdauer eingekoppelt wird, so daß die Spannung zwischen dem Eingangsknoten (4) und dem Bezugspotential auf einen in dem Meßintervall liegenden Endwert abfällt, und

    c) dann der Eingangsknoten von dem Bezugspotential und dem konstanten Spannungspotential derart entkoppelt wird, daß die Spannung auf dem Endwert gehalten wird, wobei die Auswerteschaltung (5, 6, 7) einen Ausgangswert erzeugt, der proportional zu dem Endwert ist,

    wobei der Ausgang der Auswerteschaltung (5, 6, 7) mit einer Einrichtung zum Speichern des Ausgangswerts und Bestimmen eines zugehörigen Kapazitätswerts gekoppelt ist.

11. Schaltungsanordnung nach Anspruch 10, **dadurch gekennzeichnet, daß** die Auswerteschaltung einen Operationsverstärker (5) und einen mit dem Ausgang des Operationsverstärkers gekoppelten Analog-Digital-Umsetzer (7) aufweist, wobei der Analog-Digital-Umsetzer den Ausgangswert erzeugt.

12. Schaltungsanordnung nach Anspruch 11, **dadurch gekennzeichnet, daß** der Eingangsknoten (4) mit dem invertierenden Eingang des Operationsverstärkers verbunden ist.

13. Schaltungsanordnung nach Anspruch 11 oder 12, **dadurch gekennzeichnet, daß** der Operationsverstärker (5) eine Verstärkung zwischen 2 und 1000, vorzugsweise zwischen 10 und 50, aufweist.

14. Schaltungsanordnung nach einem der Ansprüche 10 - 13, **dadurch gekennzeichnet, daß** der Eingangsknoten (4) über eine Parallelschaltung des Widerstands (18) vorgegebener Größe und einer Schaltdiode (19) mit einem Ausgangsanschluß (16) eines Controllers verbunden ist, wobei der Ausgangsanschluß (16) des Controllers auf dem Bezugspotential oder dem konstanten Spannungspotential liegen oder hochohmig sein kann, so daß die erste Schalteinrichtung von der Schaltdiode (19) und dem Controller (6) und die zweite Schalteinrichtung von dem Controller (6) gebildet wird.

15. Schaltungsanordnung nach Anspruch 14, **dadurch gekennzeichnet, daß** das Bezugspotential einem Massepotential und das konstanten Spannungspotential einem hohen Logikausgangspegel des Controllers entspricht.

**Claims**

1. A method of measuring a capacitance (1, 2), in which a voltage applied across the capacitance (1, 2) is supplied to an input (4) of an analysis circuit (5, 6, 7), wherein the analysis circuit (5, 6, 7) is so constructed that it can detect input voltages with a predetermined precision, provided that they lie within a measurement range, wherein:

(a) the capacitance (1, 2) is charged up to a predetermined initial voltage, which exceeds a multiple of an upper boundary of the measurement range,
(b) the capacitance (1, 2) is discharged via a predetermined resistor (18) for a predetermined period of time, whereby the voltage across the capacitance (1, 2) reaches a final voltage value dependent on the magnitude of the capacitance, wherein the resistor and the period of time are so selected that the final voltage value lies within the measurement range,
(c) the final voltage value is determined by the analysis circuit (5, 6, 7) and the capacitance (1, 2) is determined from the final voltage value.

2. A method as claimed in claim 1, **characterised in that** the voltage applied across the capacitance (1, 2) is fed to an input of an amplifier (5) constituting a component of the analysis circuit (5, 6, 7), that the input voltage of the amplifier (5) is then amplified, if it lies within the measurement range, by a factor of at least two so that the final voltage value is amplified by a factor of at least two and the amplified final voltage value is determined and that the amplifier (5) is driven to saturation at input voltages above the measurement range.

3. A method as claimed in claim 2, **characterised in that** the final voltage value is amplified by means of an operational amplifier (5) by a factor of between 10 and 1000, preferably between 10 and 50.

4. A method as claimed in claim 2 or 3, **characterised in that** the amplified final voltage value is determined by producing a digital final value by means of an analogue-digital convertor (7) and the digital final value produced is stored.

5. A method as claimed in one of claim 1-4, **characterised in that** the voltage across the capacitance is maintained for a second predetermined period of time after reaching the final voltage value whilst the final voltage value is determined.

6. A method as claimed in claim 5, **characterised in that** the charging up to the initial voltage, the discharging via the resistor (18) and the holding of the voltage is effected by alternately connecting and disconnecting a node connected to a connector of the capacitor with a voltage source or an earth potential, wherein the connecting and disconnecting is effected with the aid of switches, which are controlled by a control device (6).

7. A method as claimed in one of claims 1-6, **characterised in that** the initial voltage is provided by a constant voltage source.

8. A method as claimed in one of claims 1-7, **characterised in that** the predetermined period of time is determined by a processor in dependence on a timing signal.

9. A method as claimed in claim 6, **characterised in that** the control device (6) includes a processor and that the predetermined period of time is determined by the processor in dependence on a timing signal.

**10.** A circuit arrangement for measuring a capacitance of a capacitor (1, 2) in which one connection of the capacitor is connected to an input node (4) of an analysis circuit (5, 6, 7) and the other connection (3) of the capacitor is connected to a reference potential, wherein the analysis circuit (5, 6, 7) is so constructed that it determines an input voltage with a predetermined precision, provided it lies within a measurement range, and produces a corresponding initial value, wherein a first circuit device (19, 6) can connect the input node to a constant voltage potential, wherein a second circuit device can connect a resistor (18) of predetermined magnitude between the input node (4) and the reference potential, wherein a control device (6) is coupled to the first and the second switching device and controls them such that

(a) the input node (4) is connected to the constant voltage potential, wherein the analysis circuit produces an initial value which then adopts an extreme value when the input node is at the constant voltage potential,
(b) the resistor (18) is then connected between the input node (4) and the reference potential for a predetermined period of time so that the voltage between the input node (4) and the voltage potential falls to a final value lying within the measurement range, and
(c) the input node is then disconnected from the reference potential and the constant voltage potential such that the voltage is held at the final value, whereby the analysis circuit (5, 6, 7) produces an output value which is proportional to the final value,

wherein the output of the analysis circuit (5, 6, 7) is connected to a device for storing the output value and determining an associated capacitance value.

**11.** A circuit arrangement as claimed in claim 10, **characterised in that** the analysis circuit includes an operational amplifier (5) and an analogue-digital convertor (7) connected to the output of the operational amplifier, whereby the analogue-digital convertor produces the output value.

**12.** A circuit arrangement as claimed in claim 11, **characterised in that** the input node (4) is connected to the inverting input of the operational amplifier.

**13.** A circuit arrangement as claimed in claim 11 or 12, **characterised in that** the operational amplifier (5) has an amplification of between 2 and 1000, preferably between 10 and 50.

**14.** A circuit arrangement as claimed in one of claims 10-13, **characterised in that the** input node (4) is connected to an output connection (16) of a controller via a parallel circuit of the resistor (18) of predetermined magnitude and a switching diode (19), wherein the output connection (16) of the controller can be at the reference potential or the constant voltage potential or can be of high resistance, so that the first switching device is constituted by the switching diode (19) and the controller (6) and the second switching device is constituted by the controller (6).

**15.** A circuit assembly as claimed in claim 14, **characterised in that** the reference potential corresponds to an earth potential and the constant voltage potential corresponds to a high logic output level of the controller.

**Revendications**

**1.** Procédé de mesure d'une capacité de condensateur (1, 2), dans lequel une tension appliquée au condensateur (1, 2) est acheminée à une entrée (4) d'un circuit d'exploitation (5, 6, 7), dans lequel le circuit d' exploitation (5, 6, 7) est conformé de sorte qu'il puisse enregistrer des tensions d'entrée, pour autant qu'elles se situent dans un certain intervalle de mesure, avec une précision prédéterminée, dans lequel :

a) le condensateur (1, 2) est chargé à une tension d'entrée prédéterminée qui dépasse un multiple d'une limite supérieure de l'intervalle de mesure,
b) le condensateur (1, 2) est déchargé dans une résistance prédéterminée (18) pendant une période de temps prédéterminée, de sorte que la tension appliquée au condensateur (1, 2) atteigne une valeur finale de tension qui dépend de la grandeur de la capacité (1, 2), la résistance et l'intervalle de temps étant choisis de manière que la valeur finale de la tension se situe dans l'intervalle de mesure,
c) la valeur finale de la tension est enregistrée par le circuit d'exploitation (5, 6, 7) et la capacité (1, 2) est déterminée à partir de la valeur finale de la tension.

**2.** Procédé selon la revendication 1, **caractérisé en ce que** :

la tension appliquée au condensateur (1, 2) est acheminée à une entrée d'un amplificateur (5) en tant que composant du circuit d'exploitation (5, 6, 7),
la tension d'entrée de l'amplificateur (5), pour autant qu'elle se situe dans l'intervalle de mesure, est amplifiée au moins du facteur 2, de sorte que la valeur finale de la tension soit amplifiée d'au moins le facteur 2 et que la valeur finale de la tension amplifiée soit enregistrée, et l'amplificateur (5) est saturé à des tensions d'entrée situées au-dessus de l'intervalle de mesure.

3. Procédé selon la revendication 2, **caractérisée en ce que** la valeur finale de la tension est amplifiée à l'aide d'un amplificateur opérationnel (5) d'un facteur compris entre 10 et 1000, de préférence, entre 10 et 50.

4. Procédé selon la revendication 2 ou 3, **caractérisé en ce que** la valeur finale de la tension amplifiée est enregistrée en produisant, au moyen d'un convertisseur analogique-numérique (7), une valeur finale numérique et en enregistrant la valeur finale numérique obtenue.

5. Procédé selon l'une quelconque des revendications 1 à 4, **caractérisé en ce que** la tension est maintenue sur le condensateur, après que la valeur finale de la tension a été atteinte, pendant un second intervalle de temps prédéterminé, tandis que la valeur finale de la tension est enregistrée.

6. Procédé selon la revendication 5, **caractérisé en ce que** le chargement à la tension d'entrée, le déchargement via la résistance (18) et le maintien de la tension par une connexion discontinue et un désaccouplement d'un noeud raccordé à une connexion du condensateur se font avec une source de tension ou un potentiel de masse, dans lequel la connexion et le désaccouplement se font à l'aide de commutateurs qui sont commandés par un dispositif de commande (6).

7. Procédé selon l'une quelconque des revendications 1 à 6, **caractérisé en ce que** la tension d'entrée est réglée par une source de tension constante.

8. Procédé selon l'une quelconque des revendications 1 à 7, **caractérisé en ce que** l'intervalle de temps prédéterminé est déterminé par un processeur en fonction d'un signal de synchronisation.

9. Procédé selon la revendication 6, **caractérisé en ce que** le dispositif de commande (6) comprend un processeur et l'intervalle de temps prédéterminé est déterminé par le processeur en fonction d'un signal de synchronisation.

10. Aménagement de commutation pour la mesure de la capacité d'un condensateur (1, 2), dans lequel une connexion du condensateur est raccordée à un noeud d'entrée (4) d'un circuit d' exploitation (5, 6, 7) et l'autre connexion (3) du condensateur à un potentiel de référence, dans lequel le circuit d'exploitation (5, 6, 7) est conformé de manière à enregistrer une tension d'entrée, pour autant que celle-ci se trouve dans un certain intervalle de mesure, avec une précision prédéterminée et produise une valeur de sortie correspondante, dans lequel un premier dispositif de commutation (19, 6) peut connecter le noeud d'entrée à un potentiel de tension constante, dans lequel un deuxième dispositif de commutation peut injecter une résistance (18) de grandeur prédéterminée entre le noeud d'entrée (4) et le potentiel de référence, dans lequel un dispositif de commande (6) est couplé au premier et au deuxième dispositif de commutation et commande ceux-ci de sorte :

    a) que le noeud d'entrée (4) soit connecté au potentiel de tension constante, dans lequel le circuit d'exploitation produit une valeur de sortie qui, pour autant que le noeud d'entrée se situe au potentiel de tension constante, adopte une valeur extrême,
    b) que la résistance (18) entre le noeud d'entrée (4) et le potentiel de référence soit injectée pendant un intervalle de temps prédéterminé, de manière que la tension entre le noeud d'entrée (4) et le potentiel de référence tombe à une valeur qui se situe dans l'intervalle de mesure, et
    c) que le noeud d'entrée soit désaccouplé du potentiel de référence et du potentiel de tension constante, de manière que la tension soit maintenue à la valeur finale, le circuit d'exploitation (5, 6, 7) produisant une valeur de sortie qui est proportionnelle à la valeur finale,

dans lequel la sortie du circuit d'exploitation (5, 6, 7) est couplée à un dispositif permettant de mémoriser la valeur de sortie et de déterminer une valeur de capacité correspondante.

11. Aménagement de commutation selon la revendication 10, **caractérisé en ce que** le circuit d'exploitation présente un amplificateur opérationnel (5) et un convertisseur analogique-numérique (7) couplé à la sortie de amplificateur opérationnel, dans lequel le convertisseur analogique-numérique produit la valeur de sortie.

12. Aménagement de commutation selon la revendication 11, **caractérisé en ce que** le noeud d'entrée (4) est connecté à l'entrée inverseuse de l'amplificateur opérationnel.

13. Aménagement de commutation selon la revendication 11 ou 12, **caractérisé en ce que** l'amplificateur opérationnel (5) présente une amplification entre 2 et 1000, de préférence, entre 10 et 50.

14. Aménagement de commutation selon l'une quelconque des

revendications 10 à 13, **caractérisé en ce que** :

le noeud d'entrée (4) est connecté via un circuit parallèle de la résistance (18) de grandeur prédéterminée et d'une diode de commutation (19) à une connexion de sortie (16) d'un dispositif de commande,

dans lequel la connexion de sortie (16) du dispositif de commande peut se situer au potentiel de référence ou au potentiel de tension constante ou peut être fortement ohmique,

de sorte que le premier dispositif de commutation soit formé par la diode de commutation (19) et le dispositif de commande (6) et que le deuxième dispositif de commutation par le dispositif de commande (6).

15. Aménagement de commutation selon la revendication 14, **caractérisé en ce que** le potentiel de référence correspond à un potentiel de masse et le potentiel de tension constante à un niveau de sortie logique élevé du dispositif de commande.

Fig. 1

Fig. 2A

Fig. 2B

**EP 2 013 631 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5586042 A
- US 6661239 B1